# EUROPÄISCHE PATENTSCHRIFT

(11) **EP 1 935 223 B1**
(45) Veröffentlichungstag und Bekanntmachung des Hinweises auf die Patenterteilung: **20.01.2010**
(21) Anmeldenummer: 07729294.4
(22) Anmeldetag: 21.05.2007
(51) Int. Cl.: H05K 13/04

(54) **VERFAHREN ZUM BESTÜCKEN EINES SUBSTRATS MIT ELEKTRISCHEN BAUTEILEN UND BESTÜCKAUTOMAT**
METHOD FOR POPULATING A SUBSTRATE WITH ELECTRICAL COMPONENTS AND AUTOMATIC PLACEMENT MACHINE
PROCÉDÉ D'IMPLANTATION DE COMPOSANTS ÉLECTRIQUES SUR UN SUBSTRAT ET AUTOMATE D'IMPLANTATION

(30) Priorität: 13.06.2006 DE 102006027411
(43) Veröffentlichungstag der Anmeldung: 25.06.2008
(73) Patentinhaber: Siemens Electronics Assembly Systems GmbH & Co. KG, 81379 München (DE)
(72) Erfinder: MEHDIANPOUR, Mohammad, 81829 München (DE); TOMAZ, Borislav, 80686 München (DE)
(86) Internationale Anmeldenummer: PCT/EP2007/054850
(87) Internationale Veröffentlichungsnummer: WO 2007/144245

(56) Entgegenhaltungen:
- EP-A2- 0 821 549
- WO-A-99/53741

## Beschreibung

Die Erfindung betrifft ein Verfahren zum Bestücken eines Substrats mit elektrischen Bauteilen und einen Bestückautomaten zur Durchführung des Verfahrens.

Aus der EP-1072181 ist ein Bestückautomat bekannt, bei dem ein zu bestückendes Substrat in einer Bestückebene angeordnet ist. Das Substrat wird mittels eines Bestückkopfes, welcher parallel zur Bestückebene verfahrbar ist, mit elektrischen Bauteilen bestückt. Der Bestückkopf weist einen Stator und einen relativ zum Stator drehbaren Rotor, sowie mehrere Bauteilhalter auf, welche sich in einer zur Bestückebene parallelen Ebene befinden.

EP-A-0 82 1349 offenbart ein Verfahren zum Bestücken eines Substrats, das alle Merkmale des ersten Teils des Anspruchs 1 aufweist sowie einen Bestückautomaten dafür.

Es ist die Aufgabe der vorliegenden Erfindung, ein Bestückverfahren sowie einen entsprechend ausgebildeten Bestückautomaten zu liefern, mittels welcher die Bestückleistung erhöht werden kann.

Diese Aufgabe wird durch das Bestückverfahren und den Bestückautomaten gemäß den unabhängigen Ansprüchen erfüllt. Vorteilhafte Ausgestaltungen sind Gegenstand der abhängigen Ansprüche.

Das Bestückverfahren gemäß dem unabhängigen Anspruch 1 bezieht sich auf einen Bestückautomaten, bei dem das zu bestückende Substrat in einer Bestückebene angeordnet ist. Der Bestückautomat umfasst einen parallel zur Bestückebene verfahrbaren Bestückkopf mit einem Stator und einem relativ zum Stator drehbaren Rotor. Am Rotor des Bestückkopfes sind mindestens zwei Bauteilhalter derart angeordnet, dass sie sich in einer zur Bestückebene parallelen Ebene befinden. Das Verfahren zeichnet sich dadurch aus, dass der Rotor denjenigen der Bauteilhalter, welcher als Nächster ein Bauteil an einer Bestückposition auf dem Substrat abzusetzen hat, von einer ersten Ausgangsposition in eine erste Arbeitsposition dreht, deren Abstand zur Bestückposition kleiner ist als der Abstand der ersten Ausgangsposition zur Bestückposition. Dadurch, dass der Rotor denjenigen Bauteilhalter, welcher als unmittelbar Nächster einen Bestückvorgang auf dem Substrat durchzuführen hat, relativ zum Stator in die erste Arbeitsposition dreht, welche der Bestückposition auf dem Substrat näher ist als die erste Ausgangsposition, in welcher sich der Bauteilhalter vor der Drehung befand, wird der von dem Bestückkopf zurückzulegende Verfahrweg zur Bestückposition deutlich verkürzt. Aufgrund der meist großen Anzahl der zu verbauenden Bauteile ergibt sich in Summe eine deutlich gesteigerte Bestückleistung.

In einer vorteilhaften Ausgestaltung des Verfahrens nach Anspruch 2 wird der Rotor derart gedreht, dass mindestens zwei Bauteilhalter gleichzeitig Bauteile auf dem Substrat absetzen können. Die mindestens zwei Bauteilhalter nehmen daher in der ersten Arbeitsposition relativ zum Substrat eine Lage ein, in der sie nach Erreichen der entsprechend zugeordneten Bestückpositionen auf dem Substrat gleichzeitig Bauteile absetzen können. Dieses ist beispielsweise dann möglich, wenn zumindest zwei Bestückpositionen auf dem Substrat dieselbe relative Lage zueinander haben wie die entsprechenden Bauteilhalter am Rotor. Dadurch ist es möglich, die Bestückleistung noch weiter zu erhöhen.

In einer weiteren Ausgestaltung des Verfahrens nach Anspruch 3 dreht der Rotor den Bauteilhalter, welcher als Nächster ein Bauteil an einer Abholposition einer Zuführeinrichtung für die Bauteile abzuholen hat, von einer zweiten Ausgangsposition in eine zweite Arbeitsposition, wobei der Abstand der zweiten Arbeitsposition zur Abholposition kleiner ist als der Abstand der zweiten Ausgangsposition zur Abholposition. Analog zum Bestückvorgang ergeben sich somit auch beim Abholen der Bauteile an den Zuführeinrichtungen des Bestückautomaten verkürzte Verfahrwege für den Bestückkopf. Somit kann die Bestückleistung des Bestückautomaten noch weiter gesteigert werden.

Es ist gemäß der Ausgestaltung nach Anspruch 4 möglich, hinsichtlich des Abholvorganges der Bauteile an der Zuführeinrichtung den Rotor derart zu drehen, dass mindestens zwei Bauteilhalter gleichzeitig Bauteile von der Bauteilezuführeinrichtung aufnehmen können. Hierdurch kann die Bestückleistung noch weiter gesteigert werden. Die mindestens zwei Bauteilhalter nehmen daher in der zweiten Arbeitsposition relativ zur Zuführeinrichtung eine Lage ein, in der sie nach Erreichen der entsprechend zugeordneten Abholpositionen an der Zuführeinrichtung gleichzeitig Bauteile abholen können. Dieses ist beispielsweise dann möglich, wenn zumindest zwei Abholpositionen an der Zuführeinrichtung dieselbe relative Lage zueinander haben wie die entsprechenden Bauteilhalter am Rotor. Dadurch ist es möglich, die Bestückleistung noch weiter zu erhöhen.

In den Ausgestaltungen des Verfahrens gemäß der Ansprüche 5 und 6 dreht der Rotor den Bauteilhalter während der Bestückkopf zur Bestückposition bzw. zur Abholposition verfährt. Durch die Überlagerung der beiden Bewegungen ergibt sich ein weiterer Zeitvorteil, welcher sich vorteilhaft auf die Bestückleistung des Bestückautomaten auswirkt.

Das Verfahren kann gemäß Anspruch 7 auch dahingehend ausgestaltet werden, dass der Bauteilhalter mittels eines Drehantriebs um seine Längsachse relativ zum Rotor um denselben Drehwinkelbetrag in einer der Drehrichtung des Rotors entgegengesetzten Drehrichtung gedreht wird. Da sich durch die Drehung des Rotors die Winkellage eines von dem Bauteilhalter gehaltenen Bauteiles relativ zum Substrat ändert, kann dies durch die Drehung des Bauteilhalters um seine Längsachse in der entgegengesetzten Richtung um denselben Winkelbetrag ausgeglichen werden, so dass die Winkellage des Bauteiles relativ zum Substrat konstant bleibt. Vorteilhafterweise geschieht diese Drehung des Bauteilhalters um seine Längsachse schon während der Drehung des Rotors, so dass keine zeitlichen Verzüge auftreten. Bei Ankunft des Bauteiles an der Bestückposition kann dieses in der vorgegebenen Winkellage direkt auf dem Substrat ohne Korrektur abgesetzt werden.

Die Ansprüche 8 bis 14 betreffen einen Bestückautomaten mit einer Steuereinrichtung, welche derart ausgebildet ist, dass das Verfahren gemäß den Ansprüchen 1 bis 7 durchgeführt werden kann. Bezüglich der Vorteile wird auf die entsprechenden Verfahrensansprüche verwiesen.

Im Folgenden wird ein Ausführungsbeispiel des Bestückverfahrens sowie des Bestückautomaten unter Bezug auf die beigefügten Figuren näher erläutert. In den Figuren sind:
Figur 1 eine schematische Darstellung eines Bestückautomaten,
Figuren 2A, 2B, 2C schematische Darstellungen eines Bestückkopfes des Bestückautomaten,
Figuren 3 bis 9 Prinzipdarstellungen des Bestückverfahrens.

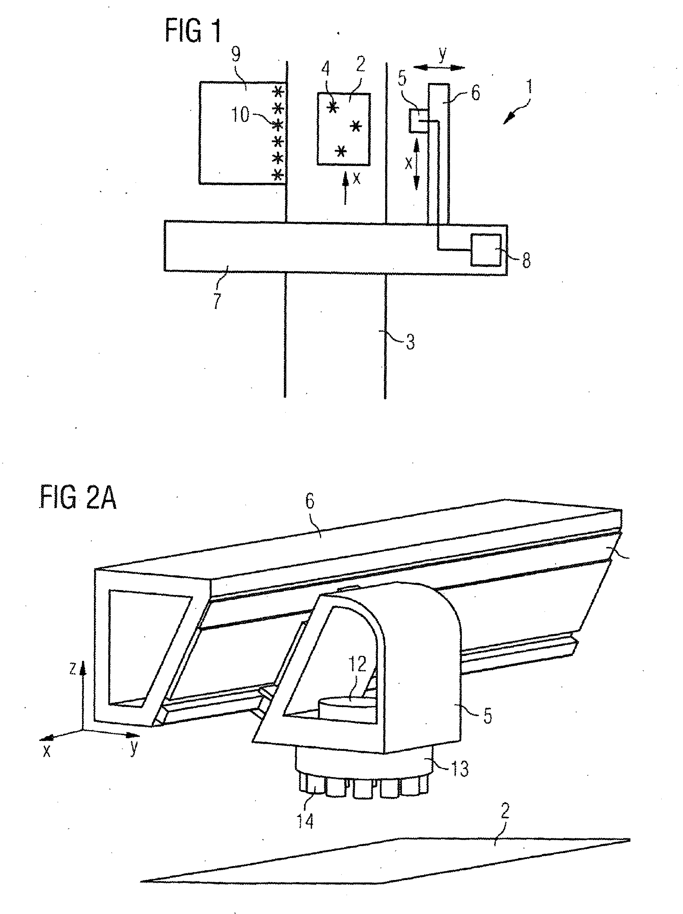

In Figur 1 ist ein Bestückautomat 1 zum Bestücken von Substraten in elektrischen Bauteilen schematisch dargestellt. Die zu bestückenden Substrate 2 werden mittels einer Transporteinrichtung 3, beispielsweise eines Transportbands, in einer Förderrichtung (Pfeil X) zu einem Bestückplatz am Bestückautomaten 1 transportiert. Dabei sind die Substrate 2 in einer Bestückebene angeordnet. Die Substrate 2 weisen definierte Bestückpositionen 4 (als Sterne gekennzeichnet) auf, an welchen die elektrischen Bauteile abzusetzen sind. Dazu verfügt der Bestückautomat 1 über einen Bestückkopf 5, welcher in einer zur Bestückebene parallelen Ebene über dem Substrat 2 verfahrbar ist. Der Bestückkopf 5 ist an einem Positionierarm 6 verfahrbar (Pfeil X) angeordnet. Der Positionierarm 6 ist wiederum verschiebbar (Pfeil Y) an einem Träger 7 angebracht, welcher die Transporteinrichtung 3 quer zur Förderrichtung brückenartig überspannt.

Zur Steuerung des Bestückvorgangs verfügt der Bestückautomat 1 über eine Steuereinrichtung 8, welche unter anderem mit dem Bestückkopf 5 und dem Positionierarm 6 gekoppelt ist. Somit kann die Steuereinrichtung 8 alle Abläufe am Bestückkopf 5 und dessen Bewegung mittels des Positionierarms 6 steuern.

Seitlich der Transportstrecke ist in einem Zuführbereich eine Zuführeinrichtung 9 für die elektrischen Bauteile vorgesehen. Die Zuführeinrichtung 9 stellt die Bauteile an einer oder mehreren definierten Abholpositionen 10 (als Sterne dargestellt) für den Bestückkopf 5 bereit. Vor dem Bestücken des Substrats 2 wird der Bestückkopf 5 deshalb zunächst in den Zuführbereich verfahren, um dort Bauteile an den Abholpositionen 10 aufzunehmen. Anschließend wird der Bestückkopf 5 in einen Bestückbereich verfahren, wo das zu bestückende Substrat 2 bereitliegt. Dort werden die Bauteile an den Bestückpositionen 4 auf dem Substrat 2 abgesetzt.

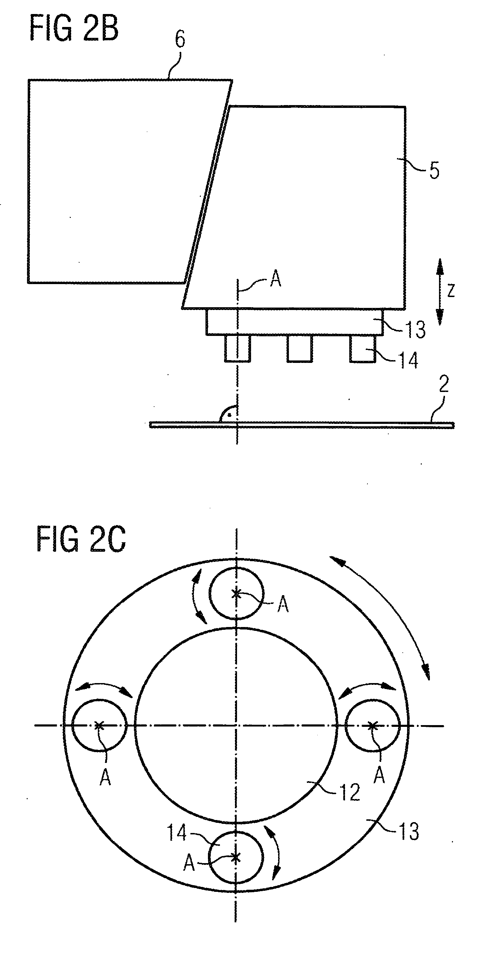

In den Figuren 2A und 2B sind der Positionierarm 6, der daran befestigte Bestückkopf 5 und das zu bestückende Substrat 2 perspektivisch und in der Seitenansicht dargestellt. Figur 2C stellt eine stark vereinfachte Ansicht des Bestückkopfes 5 5 senkrecht auf die Bestückebene dar.

Die zu bestückende Oberfläche des Substrats 2 definiert die Bestückebene. Der Bestückkopf 5 ist an einer am Positionierarm 6 vorgesehenen Linearführung 11 verschieblich (Pfeil X) gelagert (siehe Figur 2A). Der Bestückkopf 5 weist einen Stator 12 und einen relativ zum Stator 12 drehbar gelagerten Rotor 13 auf, an welchem mehrere Bauteilhalter 14 zum Halten der Bauteile (nicht dargstellt) angeordnet sind. Dabei sind die Bauteilhalter 14 derart am Rotor 13 angeordnet, dass sie sich in einer zur Bestückebene des Substrats 2 parallelen Ebene befinden (siehe Figur 2B). Die Längsachsen A der Bauteilhalter 14 sind dabei senkrecht zur Bestückebene bzw. zur Substratoberfläche gerichtet. Jeder Bauteilhalter 14 ist individuell in einer Richtung senkrecht zur Bestückebene (Pfeil Z) bewegbar bzw. absenkbar, um Bauteile von den Zuführeinrichtungen aufzunehmen oder sie auf dem Substrat 2 abzusetzen (siehe Figur 2B). Wie aus Figur 2C hervorgeht, kann jeder der Bauteilhalter 14 mittels eines eigenen Drehantriebs (nicht dargestellt) individuell relativ zum Rotor 13 um seine Längsachse A gedreht werden.

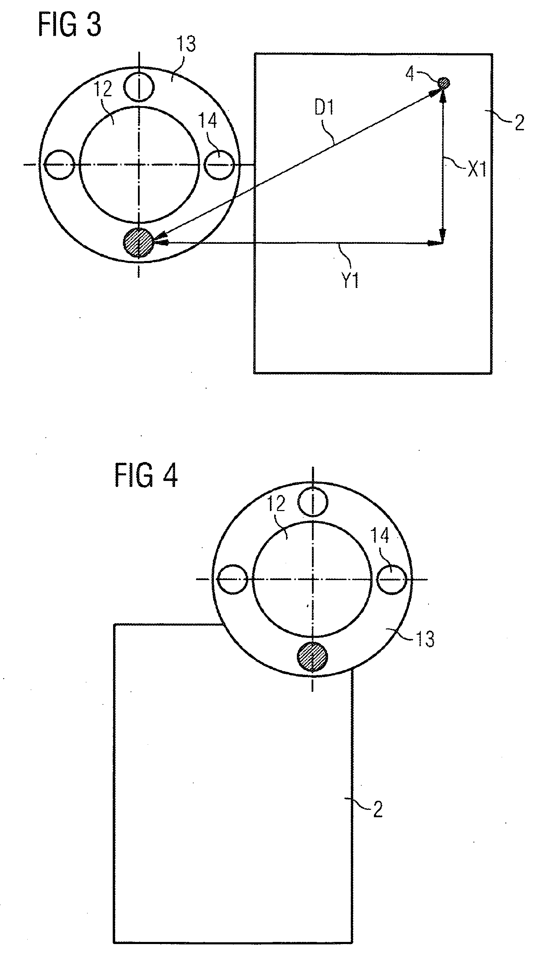

Wie in Bezug auf Figur 1 schon beschrieben wurde, verfügt der Bestückautomat 1 über eine Steuereinrichtung 8, welche den Bestückvorgang steuert. Ein Ausführungsbeispiel eines derartigen Bestückverfahrens wird im Folgenden anhand der Figuren 3 bis 9 näher erläutert. In den Figuren 3 bis 9 sind der Bestückkopf 5 und das zu bestückende Substrat 2 schematisch und in vereinfachter Form dargestellt. Zur besseren Übersichtlichkeit sind vom Bestückkopf 5 nur der Rotor 13, eine reduzierte Anzahl von 4 Bauteilhaltern, sowie der Stator 12 dargestellt. Das Substrat 2 ist vereinfacht als Rechteck dargestellt, wobei eine Bestückposition 4, auf welcher von dem Bestückkopf 5 ein Bauteil abzusetzen ist, als Punkt gekennzeichnet ist. Ferner sind diejenigen Bauteilhalter 14, welche ein Bauteil halten, durch ausgefüllte Kreise und diejenigen Bauteilhalter 14, welche kein Bauteil halten, durch Leerkreise dargestellt. Die Figuren 3 bis 9 stellen den Bestückkopf 5 und das Substrat 2 in der Draufsicht senkrecht zur Bestückebene dar.

In Figur 3 befindet sich der Bestückkopf 5 relativ zum Substrat 2 in einer ersten Ausgangsposition. Der als ausgefüllter Kreis gekennzeichnete Bauteilhalter 14 soll als unmittelbar nächster Bauteilhalter 14 das von ihm gehaltene Bauteil an der dafür vorgesehenen Bestückposition 4 auf dem Substrat 2 absetzen. In der ersten Ausgangsposition befindet sich der Bauteilhalter 14 um einen Abstand D1 von der Bestückposition 4 auf dem Substrat 2 entfernt. Würde der Bauteilhalter 14 mit dem Bauteil unter Einbehaltung seiner Relativlage zum Stator 12, d. h. ohne Drehung des Rotors 13, und lediglich durch Verschiebung entlang der Linearachsen X und Y zu der Bestückposition 4 bewegt werden, so müssten in Richtung der Y-Achse die Strecke Y1 und entlang der X-Achse die Strecke X1 zurückgelegt werden. In Figur 4 ist der Bestückkopf 5 nach Erreichen der Abholposition 10 dargestellt.

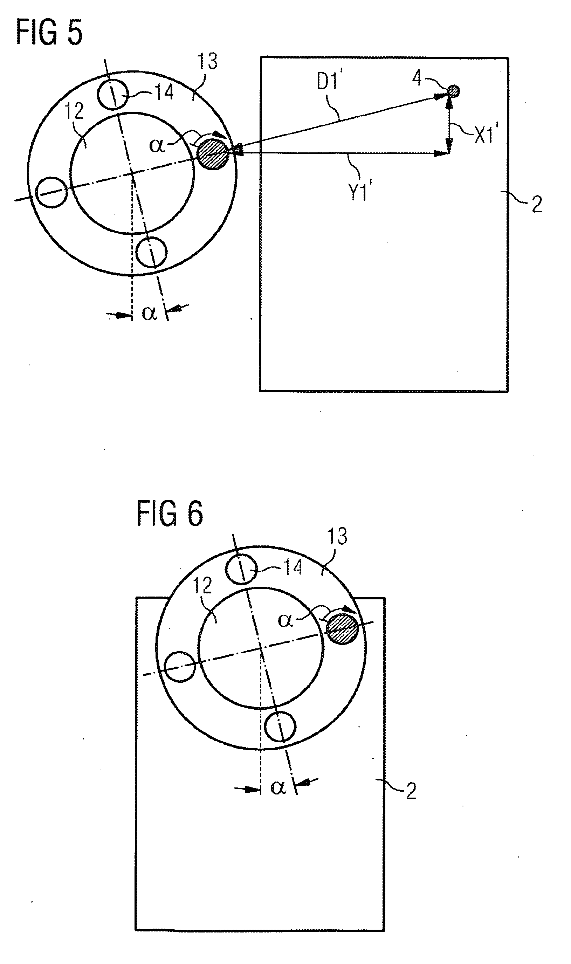

In den Figuren 5 und 6 wird das Bestückverfahren nun derart durchgeführt, dass der Rotor 13 denjenigen Bauteilhalter 14 (als ausgefüllter Kreis gekennzeichnet), welcher als nächster Bauteilhalter 14 ein Bauteil an der im zugeordneten Bestückposition 4 auf dem Substrat 2 abzusetzen hat, von der ersten Ausgangsposition (siehe Figur 3) relativ zum Stator 12 um den Drehwinkel α in eine erste Arbeitsposition dreht, deren Abstand D1' zur Bestückposition 4 kleiner ist als der Abstand D1 der ersten Ausgangsposition zur Bestückposition 4. Nach Einnahme der ersten Arbeitsposition muss der Bauteilhalter 14 zum Erreichen der Bestückposition 4 lediglich um die Strecken Y1' und X1' verfahren werden, welche deutlich kürzer sind als die in Figur 3 dargestellten Strecken Y1 und X1. Die Drehung des Rotors 13 kann beispielsweise vor dem Verfahren des Bestückkopfes 5 zu der Bestückposition 4 durchgeführt werden. Vorzugsweise jedoch wird die Drehung des Rotors 13 während des Bewegens des Bestückkopfes 5 zur Bestückposition 4 durchgeführt. Die simultane Drehung des Rotors 13 und Verschiebung des Bestückkopfes 5 spart zusätzlich Zeit ein, wodurch die Bestückleistung erhöht werden kann. Um die Verfahrstrecke des Bestückkopfes 5 zur Bestückposition 4 zu minimieren, ist die erste Arbeitsposition so zu wählen, dass der Abstand zur Bestückposition 4 minimal ist. Im Ausführungsbeispiel gemäß Figur 5 ist dies der Fall, wenn die Bestückposition 4, der Bauteilhalter 14 bzw. die erste Arbeitsposition und die Drehachse des Rotors 13 auf einer Geraden liegen.

In Figur 6 ist der Bestückkopf 5 bei Erreichen der Bestückposition 4 dargestellt.

Der Bauteilhalter 14 kann mittels seines Drehantriebes (nicht dargestellt) um seine Längsachse A (Figur 2B) um denselben Drehwinkelbetrag |α| in einer zur Drehrichtung des Rotors 13 entgegengesetzten Drehrichtung gedreht werden. Dadurch wird erreicht, dass die Winkelposition des Bauteils relativ zum Substrat 2 bei Erreichen der Bestückposition 4 unverändert bleibt. Diese Drehung des Bauteilhalters um seine Längsachse A geschieht vorzugsweise gleichzeitig mit der Drehung des Rotors 13.

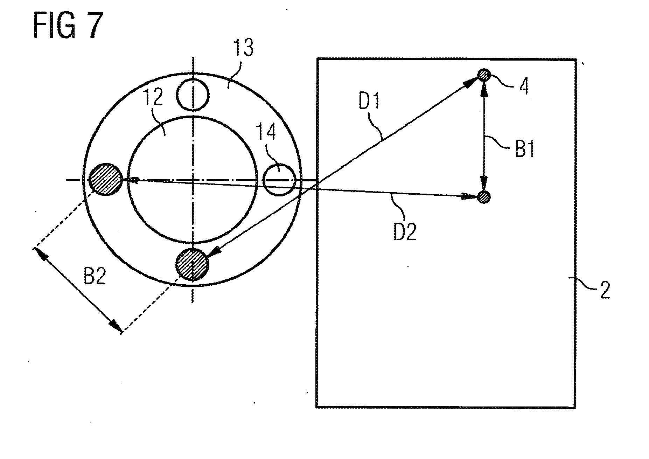

In den Figuren 7, 8 und 9 ist eine Ausgestaltung des Bestückverfahrens dargestellt, bei der gleichzeitig zwei Bauteile auf dem Substrat 2 abgesetzt werden. In Figur 7 ist der Bestückkopf 5 dargestellt, wobei diesmal zwei Bauteile an jeweils einem Bauteilhalter 14 (ausgefüllte Kreise) gehalten werden. Jedem der Bauteile ist eine bestimmte Bestückposition 4 auf dem Substrat 2 zugeordnet (durch Pfeile gekennzeichnet). Im vorliegenden Fall ist der Abstand B1 der beiden Bestückpositionen 4 identisch mit dem Abstand B2 der an den Bauteilhaltern gehaltenen Bauteile. Bei dem in Figur 7 dargestellten Bestückkopf 5 befinden sich die Bauteilhalter 14 bzw. der Rotor 13 in der ersten Ausgangsposition relativ zum Stator 12 bzw. zu den Bestückpositionen 4. Ohne Drehung des Rotors 13, d. h. bei Verharren des Rotors 13 in der ersten Ausgangsposition, müssten die Bauteile einzeln und nacheinander an den jeweils zugeordneten Bestückpositionen 4 auf dem Substrat 2 abgesetzt werden.

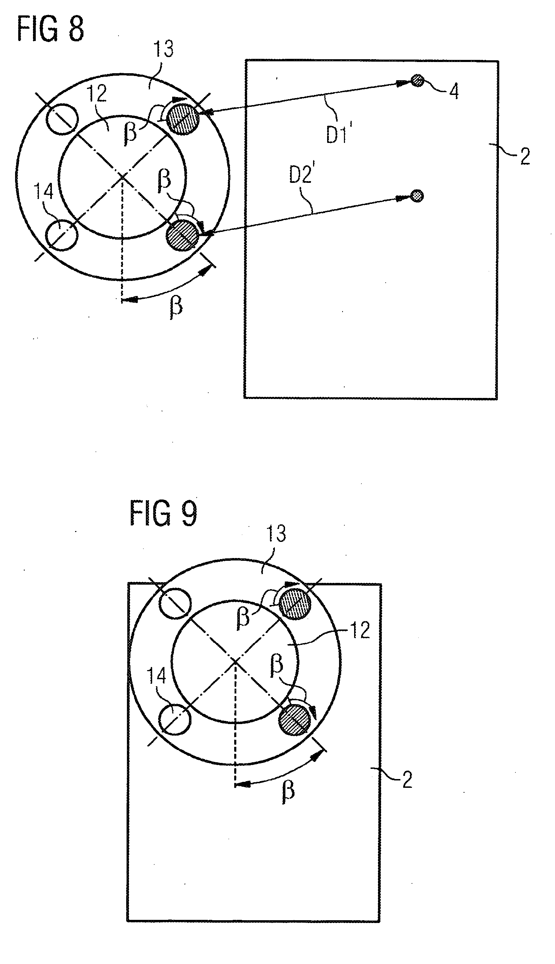

Ausgehend von der in Figur 7 dargestellten ersten Ausgangsposition kann die Bestückleistung durch Anwendung des erfindungsgemäßen Bestückverfahrens deutlich gesteigert werden. Dazu werden, wie in Figur 8 dargestellt, die beiden Bauteilhalter 14, welche als nächstes ein Bauteil auf der jeweils zugeordneten Bestückposition 4 absetzen sollen, ausgehend von der ersten Ausgangsposition (siehe Figur 7) relativ zum Stator 12 um den Drehwinkel β in die erste Arbeitsposition gedreht. In der ersten Arbeitsposition sind die Abstände D1', D2' der Bauteilhalter 14 zu den jeweils zugeordneten Bestückpositionen 4 kleiner ist als die Abstände D1, D2 der Bauteilhalters in der ersten Ausgangsposition zu den Bestückpositionen 4 (siehe Figur 7). In der ersten Arbeitsposition erlaubt die Lage der Bauteilhalter 14 relativ zu den jeweiligen Bestückpositionen 4 ein gleichzeitiges Absetzen der Bauteile auf dem Substrat 2. Nach Erreichen der Bestückpositionen 4 werden die Bauteile gleichzeitig abgesetzt. Dies ist in Figur 9 gezeigt.

Durch diese Ausgestaltung des Bestückverfahrens kann die Bestückleistung in zweifacher Hinsicht gesteigert werden. Erstens wird die vom Bestückkopf 5 zurückzulegende Distanz bis zum Erreichen der Bestückpositionen 4 deutlich verkürzt, was bei einem Vergleich der Figuren 7 und 8 deutlich wird. Darüber hinaus können zwei Bauteile gleichzeitig abgesetzt werden.

Auch hier können die Bauteilhalter 14 mittels der individuellen Drehantriebe (nicht dargestellt) um ihre Längsachse A um denselben Drehwinkelbetrag |β| in einer zur Drehrichtung des Rotors 13 entgegengesetzten Drehrichtung gedreht werden. Dadurch wird erreicht, dass die Winkelposition der Bauteile relativ zum Substrat 2 bei Erreichen der Bestückpositionen 4 unverändert bleibt.

Bei Vergleich der Figuren 4 und 6 wird ein weiterer Vorteil des Bestückverfahrens deutlich. Bei Verschieben des Bestückkopfes 5 zur Bestückposition 4 ohne entsprechende Drehung des Rotors 13, muss der Bewegungsbereich des Bestückkopfes 5 bei gleicher Substratgröße deutlich größer ausgelegt werden, als bei dem erfindungsgemäßen Bestückverfahren. Dies bringt den Nachteil mit sich, dass die Dimensionen des Positioniersystems, bestehend aus dem Positionierarm 6 und dem Träger 7, bei gleicher Substratgröße wesentlich größer ausgeführt werden müssen, was die Abmessungen des Bestückautomäten 1 vergrößern und die Kosten erhöht.

Wie in Figur 1 dargestellt ist, ist seitlich des Bestückautoamten eine Zuführeinrichtung 9 für die elektrischen Bauteile angeordnet. Die Bauteile werden dem Bestückkopf 5 an definierten Abholpositionen 10 bereitgestellt. Das anhand der Figuren 3 bis 9 erläuterte Bestückverfahren kann deshalb auch auf den Abholvorgang analog übertragen werden. Dabei dreht der Rotor 13 den Bauteilhalter 14, welcher als unmittelbar nächster Bauteilhalter 14 ein Bauteil an einer Abholposition 10 der Zuführeinrichtung 9 abzuholen hat, von einer zweiten Ausgangsposition in eine zweite Arbeitsposition, deren Abstand zur Abholposition 10 kleiner ist, als der Abstand der zweiten Ausgangsposition zur Abholposition 10. Das Abholen der Bauteile von der Zuführeinrichtung 9 kann analog zu den in den Figuren 3 bis 9 dargestellten Verfahrensschritten durchgeführt werden. Dabei wäre das in den Figur 3 bis 9 dargestellte Substrat 2 als die Zuführeinrichtung 9 anzusehen, wogegen die als Punkte dargestellten Bestückpositionen 4 als Abholpositionen 10 anzusehen wären.

Unter der Voraussetzung, dass die Zuführeinrichtung 9 mehrere Bauteile an unterschiedlichen Abholpositionen 10 gleichzeitig zur Verfügung stellt und der Abstand zwischen zwei Abholpositionen 10 genauso groß ist wir der Abstand der entsprechenden Bauteilhalter 14 am Bestückkopf 5, welche die Bauteile abzuholen haben, kann auch ein gleichzeitiges Abholen der Bauteile durchgeführt werden. Dazu muss der Rotor 13 analog dem in den Figuren 7 bis 9 dargestellten Bestückvorgang in eine Lage relativ zu den Abholpositionen 10 gedreht werden, in der beide Bauteile gleichzeitig abgeholt werden können. Durch diese Ausweitung des Bestückverfahrens auf dem Abholvorgang kann die Leistung des Bestückautomaten 1 weiter gesteigert werden.

## Patentansprüche

1. Verfahren zum Bestücken eines Substrats (2) mit elektrischen Bauteilen für einen Bestückautomaten (1), bei dem das zu bestückende Substrat (2) in einer Bestückebene angeordnet ist und welcher einen in einer zur Bestückebene parallelen Ebene verfahrbaren Bestückkopf (5) mit einem Stator (12), einem relativ zum Stator (12) drehbaren Rotor (13) und mindestens zwei Bauteilhalter (14) aufweist, welche derart an dem Rotor (13) angeordnet sind, dass sie sich in einer zur Bestückebene parallelen Ebene befinden,
wobei das Verfahren **dadurch gekennzeichnet ist, dass** der Rotor (13) denjenigen Bauteilhalter (14), welcher als nächstes ein Bauteil an einer Bestückposition (4) auf dem Substrat (2) abzusetzen hat, von einer ersten Ausgangsposition in eine erste Arbeitsposition dreht, deren Abstand zur Bestückposition (4) kleiner ist als der Abstand der ersten Ausgangsposition zur Bestückposition (4).

2. Verfahren nach Anspruch 1, wobei der Rotor (13) derart dreht, dass mindestens zwei Bauteilhalter (14) gleichzeitig Bauteile auf dem Substrat (2) absetzen können.

3. Verfahren nach Anspruch 1, wobei der Rotor (13) den Bauteilhalter (14), welcher als nächstes ein Bauteil an einer Abholposition (10) einer Zuführeinrichtung (9) für die Bauteile abzuholen hat, von einer zweiten Ausgangsposition in eine zweite Arbeitsposition dreht, deren Abstand zur Abholposition (10) kleiner ist als der Abstand der zweiten Ausgangsposition zur Abholposition (10).

4. Verfahren nach Anspruch 3, wobei der Rotor (13) derart dreht, dass mindestens zwei Bauteilhalter (14) gleichzeitig Bauteile von der Zuführeinrichtung (9) aufnehmen können.

5. Verfahren nach einem der Ansprüche 1 bis 2, wobei der Rotor (13) den Bauteilhalter (14) dreht während der Bestückkopf (5) zur Bestückposition (4) verfährt.

6. Verfahren nach einem der Ansprüche 3 bis 4, wobei der Rotor (13) den Bauteilhalter (14) dreht während der Bestückkopf (5) zur Abholposition (10) verfährt.

7. Verfahren nach einem der Ansprüche 1, 2 und 5, wobei der Bauteilhalter (14) mittels eines Drehantriebs um seine Längsachse relativ zum Rotor (13) um denselben Drehwinkelbetrag in einer der Drehrichtung des Rotors (13) entgegengesetzten Drehrichtung gedreht wird.

8. Bestückautomat (1) zum Bestücken eines in einer Bestückebene angeordneten Substrats (2) mit elektrischen Bauteilen, mit
- einem in einer Ebene parallel zur Bestückebene verfahrbaren Bestückkopf (5), welcher einen Stator (12), einen relativ zum Stator (12) drehbaren Rotor (13) und mindestens zwei Bauteilhalter (14) aufweist, wobei die Bauteilhalter (14) derart an dem Rotor (13) angeordnet sind, dass sie sich in einer zur Bestückebene parallelen Ebene befinden, und
- einer Steuereinrichtung (8), welche derart ausgebildet ist, dass der Rotor (13) denjenigen Bauteilhalter (14), welcher als nächstes ein Bauteil an einer Bestückposition (4) auf dem Substrat (2) abzusetzen hat, von einer ersten Ausgangsposition in eine erste Arbeitsposition dreht, deren Abstand zur Bestückposition (4) kleiner ist als der Abstand der ersten Ausgangsposition zur Bestückposition (4).

9. Bestückautomat (1) nach Anspruch 8, wobei die Steuereinrichtung (8) derart ausgebildet ist, dass der Rotor (13) derart dreht, dass mindestens zwei Bauteilhalter (14) gleichzeitig Bauteile auf dem Substrat (2) absetzen können.

10. Bestückautomat (1) nach Anspruch 8, wobei die Steuereinrichtung (8) derart ausgebildet ist, dass der Rotor (13) denjenigen Bauteilhalter (14), welcher als nächstes ein Bauteil an einer Abholposition (10) einer Zuführeinrichtung (9) für die Bauteile abzuholen hat, von einer zweiten Ausgangsposition in eine zweite Arbeitsposition dreht, deren Abstand zur Abholposition (10) kleiner ist als der Abstand der zweiten Ausgangsposition zur Abholposition (10).

11. Bestückautomat (1) nach Anspruch 10, wobei die Steuereinrichtung (8) derart ausgebildet ist, dass der Rotor (13) derart dreht, dass mindestens zwei Bauteilhalter (14) gleichzeitig Bauteile von der Zuführeinrichtung (9) aufnehmen können.

12. Bestückautomat (1) nach einem der Ansprüche 8 bis 9, wobei die Steuereinrichtung (8) derart ausgebildet ist, dass der Rotor (13) den Bauteilhalter (14) dreht während der Bestückkopf (5) zur Bestückposition (4) verfährt.

13. Bestückautomat (1) nach einem der Ansprüche 10 bis 11 wobei die Steuereinrichtung (8) derart ausgebildet ist, dass der Rotor (13) den Bauteilhalter (14) dreht während der Bestückkopf (5) zur Abholposition (10) verfährt.

14. Bestückautomat (1) nach einem der Ansprüche 8, 9 und 12,
wobei die Steuereinrichtung (8) derart ausgebildet ist, dass der Bauteilhalter (14) mittels eines Drehantriebs um seine Längsachse relativ zum Rotor (13) um denselben Drehwinkelbetrag in einer der Drehrichtung des Rotors (13) entgegengesetzten Drehrichtung gedreht wird.

## Claims

1. Method for populating a substrate (2) with electrical components for an automatic placement machine (1), wherein the substrate (2) to be populated is arranged in a placement plane and which has a placement head (5) - which can be moved in a plane parallel to the placement plane - with a stator (12), a rotor (13) - which can be rotated relative to the stator (12) - and at least two component holders (14) arranged on the rotor (13) in such a way that they are situated in a plane parallel to the placement plane,
wherein the method is **characterised in that** the rotor (13) rotates the placement holder (14) which next has to deposit a component at a placement position (4) on the substrate (2), from a first initial position to a first working position, the distance of the first working position from the placement position (4) being smaller than the distance of the first initial position from the placement position (4).

2. Method according to claim 1, wherein the rotor (13) rotates in such a way that at least two component holders (14) can deposit components on the substrate (2) at the same time.

3. Method according to claim 1, wherein the rotor (13) rotates the component holder (14) which next has to pick up a component at a pick-up position (10) of a feed device (9) for the components from a second initial position to a second working position, the distance of the second working position from the pick-up position (10) being smaller than the distance from the second initial position from the pick-up position (10).

4. Method according to claim 3, wherein the rotor (13) rotates in such a way that at least two component holders (14) can receive components from the feed device (9) at the same time.

5. Method according to one of claims 1 to 2, wherein the rotor (13) rotates the component holder (14) while the placement head (5) moves into the placement position (4).

6. Method according to one of claims 3 to 4, wherein the rotor (13) rotates the component holder (14) while the placement head (5) moves into the pick-up position (10).

7. Method according to one of claims 1, 2 and 5, wherein the component holder (14) is rotated about its longitudinal axis by means of a rotary drive relative to the rotor (13) by the same degree of rotation angle in a rotational direction opposite to the rotational direction of the rotor (13).

8. Automatic placement machine (1) for populating a substrate (2) arranged in a placement plane with electrical components, having:
- a placement head (5) which can be moved in a plane parallel to the placement plane and which has a stator (12), a rotor (13) rotatable relative to the stator (12), and at least two component holders (14), the component holders (14) being arranged on the rotor (13) in such a way that they are located in a plane parallel to the placement plane and
- a control device (8) which is embodied such that the rotor (13) rotates the component holder (14), which next has to deposit a component at a placement position (4) on the substrate (2), from a first initial position to a first working position, the distance of the first working position from the placement position (4) being smaller than the distance from the first initial position from the placement position (4).

9. Automatic placement machine (1) according to claim 8,
wherein the control device (8) is embodied such that the rotor (13) rotates in such a way that at least two component holders (14) can deposit components on the substrate (2) at the same time.

10. Automatic placement machine (1) according to claim 8,
wherein the control device (8) is embodied such that the rotor (13) rotates the component holder (14) which next has to pick up a component at a pick-up position (10) of a feed device (9) for the components, from a second initial position to a second working position, the distance of the second working position from the pick-up position (10) being smaller than the distance of the second initial position from the pick-up position (10).

11. Automatic placement machine (1) according to claim 10,
wherein the control device (8) is embodied such that the rotor (13) rotates in such a way that at least two component holders (14) can receive components from the feed device (9) at the same time.

12. Automatic placement machine (1) according to one of claims 8 to 9, wherein the control device (8) is embodied such that the rotor (13) rotates the component holder (14) while the placement head (5) moves into the placement position (4).

13. Automatic placement machine (1) according to one of claims 10 to 11, wherein the control device (8) is embodied such that the rotor (13) rotates the component holder (14) while the placement head (5) moves into the pick-up position (10).

14. Automatic placement machine (1) according to one of claims 8, 9 and 12, wherein the control device (8) is embodied such that the component holder (14) is rotated by means of a rotary drive about its longitudinal axis relative to the rotor (13) by the same degree of rotation angle in a rotational direction opposite to the rotational direction of the rotor (13).

## Revendications

1. Procédé pour l'équipement d'un substrat (2) avec des composants électriques pour un automate d'équipement (1), dans lequel le substrat (2) à équiper est disposé dans un plan d'équipement et qui présente une tête d'équipement (5) déplaçable dans un plan parallèle au plan d'équipement avec un stator (12), un rotor (13) pouvant tourner par rapport au stator (12) et au moins deux supports de composant (14), qui sont disposés sur le rotor (13) de telle sorte qu'ils se trouvent dans un plan parallèle au plan d'équipement, le procédé étant **caractérisé en ce que** le rotor (13) fait tourner le support de composant (14), qui, dans la prochaine étape, doit déposer un composant sur une position d'équipement (4) sur le substrat (2), d'une première position de départ dans une première position de travail, dont l'espacement à la position d'équipement (4) est inférieur à l'espacement de la première position de départ à la position d'équipement (4).

2. Procédé selon la revendication 1, le rotor (13) tournant de telle sorte qu'au moins deux supports de composant (14) peuvent déposer simultanément des composants sur le substrat (2).

3. Procédé selon la revendication 1, le rotor (13) faisant tourner le support de composant (14), qui, dans la prochaine étape, doit aller chercher un composant sur une position d'enlèvement (10) d'un dispositif d'alimentation (9) pour les composants, d'une seconde position de départ dans une seconde position de travail, dont l'espacement à la position d'enlèvement (10) est inférieur à l'espacement de la seconde position de départ à la position d'enlèvement (10).

4. Procédé selon la revendication 3, le rotor (13) tournant de telle sorte qu'au moins deux supports de composant (14) peuvent recevoir simultanément des composants du dispositif d'alimentation (9).

5. Procédé selon l'une quelconque des revendications 1 à 2, le rotor (13) faisant tourner le support de composant (14) alors que la tête d'équipement (5) se déplace vers la position d'équipement (4).

6. Procédé selon l'une quelconque des revendications 3 à 4, le rotor (13) faisant tourner le support de composant (14) alors que la tête d'équipement (5) se déplace vers la position d'enlèvement (10).

7. Procédé selon l'une quelconque des revendications 1, 2 et 5, le support de composant (14) étant tourné au moyen d'un entraînement de rotation autour de son axe longitudinal par rapport au rotor (13) de la valeur d'angle de rotation dans un sens de rotation opposé au sens de rotation du rotor (13).

8. Automate d'équipement (1) pour l'équipement d'un substrat (2) disposé dans un plan d'équipement avec des composants électriques, comprenant une tête d'équipement (5) déplaçable dans un plan parallèle au plan d'équipement, qui présente un stator (12), un rotor (13) pouvant tourner par rapport au stator (12) et au moins deux supports de composant (14), les supports de composant (14) étant disposés sur le rotor (13) de telle sorte qu'ils se trouvent dans un plan parallèle au plan d'équipement, et un dispositif de commande (8), qui est conçu de telle sorte que le rotor (13) fait tourner le support de composant (14), qui, dans la prochaine étape, doit déposer un composant sur une position d'équipement (4) sur le substrat (2), d'une première position de départ dans une première position de travail, dont l'espacement à la position d'équipement (4) est inférieur à l'espacement de la première position de départ à la position d'équipement (4).

9. Automate d'équipement (1) selon la revendication 8, le dispositif de commande (8) étant conçu de telle sorte que le rotor (13) tourne de telle sorte qu'au moins deux supports de composant (14) peuvent déposer simultanément des composants sur le substrat (2).

10. Automate d'équipement (1) selon la revendication 8, le dispositif de commande (8) étant conçu de telle sorte que le rotor (13) fait tourner le support de composant (14) qui, dans la prochaine étape, doit aller chercher un composant sur une position d'enlèvement (10) d'un dispositif d'alimentation (9) pour les composants, d'une seconde position de départ dans une seconde position de travail, dont l'espacement à la position d'enlèvement (10) est inférieur à l'espacement de la seconde position de départ à la position d'enlèvement (10).

11. Automate d'équipement (1) selon la revendication 10, le dispositif de commande (8) étant conçu de telle sorte que le rotor (13) tourne de telle sorte qu'au moins deux supports de composant (14) peuvent recevoir simultanément des composants du dispositif d'alimentation (9).

12. Automate d'équipement (1) selon l'une quelconque des revendications 8 à 9, le dispositif de commande (8) étant conçu de telle sorte que le rotor (13) fait tourner le support de composant (14) alors que la tête d'équipement (5) se déplace vers la position d'équipement (4).

13. Automate d'équipement (1) selon l'une quelconque des revendications 10 à 11, le dispositif de commande (8) étant conçu de telle sorte que le rotor (13) fait tourner le support de composant (14) alors que la tête d'équipement (5) se déplace vers la position d'enlèvement (10).

14. Automate d'équipement (1) selon l'une quelconque des revendications 8, 9 et 12, le dispositif de commande (8) étant conçu de telle sorte que le support de composant (14) est tourné au moyen d'un entraînement de rotation autour de son axe longitudinal par rapport au rotor (13) de la même valeur d'angle de rotation dans un sens de rotation opposé au sens de rotation du rotor (13).
